# EUROPEAN PATENT SPECIFICATION

(11) **EP 4 657 522 B1**
(45) Date of publication and mention of the grant of the patent: **11.11.2026**
(21) Application number: 25177612.6
(22) Date of filing: 20.05.2025
(51) Int. Cl.: H10W 40/22, H10W 70/02, H10W 70/40, H10W 70/60, H10W 40/00, H10W 40/20, H10W 40/25, H10W 70/04, H10W 74/01, H10W 74/10

(54) **SEMICONDUCTOR DEVICE AND METHOD OF MANUFACTURING THE SEMICONDUCTOR DEVICE**
HALBLEITERBAUELEMENT UND VERFAHREN ZUR HERSTELLUNG DES HALBLEITERBAUELEMENTS
DISPOSITIF SEMI-CONDUCTEUR ET PROCÉDÉ DE FABRICATION DU DISPOSITIF SEMI-CONDUCTEUR

(30) Priority: 28.05.2024 JP 2024086442
(43) Date of publication of application: 03.12.2025
(73) Proprietor: SHINKO ELECTRIC INDUSTRIES CO., LTD., Nagano-shi, Nagano 381-2287 (JP)
(72) Inventor: NISHIHARA, Yoichi, Nagano-shi, Nagano, 381-2287 (JP)
(74) Representative: Hoffmann Eitle

(56) References cited:
- WO-A1-2018/111484
- US-A1- 2012 126 401
- US-A1- 2014 138 806
- US-A1- 2019 043 734
- US-A1- 2020 266 132
- US-A1- 2022 181 287
- US-B1- 6 306 680

## Description

### FIELD

The embodiment discussed herein is related to a semiconductor device and a method of manufacturing the semiconductor device.

### BACKGROUND

Conventionally, there is a known semiconductor device having a structure in which, for example, an electronic component, such as a semiconductor element, is arranged on one of surfaces of an insulating base material by way of an adhesive layer, and a wiring layer is formed on the other of the surfaces of the insulating base material. In such a semiconductor device, the wiring layer is connected to the electronic component by way of a via that passes through the insulating base material and the adhesive layer. In this way, as a result of the wiring layer being connected to the electronic component by way of the via, heat generated from the electronic component is radiated to the outside by way of passing through the wiring layer and the via.

Furthermore, in order to increase a heat radiation path from the electronic component, in some cases, a metal plate functioning as a heat sink is arranged so as to sandwich the electronic component with the insulating base material, and the electronic component is bonded to the metal plate.

J P 2008 - 198 607 A relates to a MEMS (micro electromechanical system) switch capable of being operated by high input/output current, and interconnecting method and packaging method applicable to a MEMS relay.

US 6 306 680 B1 relates toa power semiconductor device package that includes at least one power semiconductor device mounted onto at least one electrically and thermally conductive spacer having an upper end surface bonded to a back surface of the device, a substrate of hardened substrate molding material surrounding the semiconductor device and the spacer except for an active major surface of the device and an lower end surface of the spacer, a dielectric film overlying the device active major surface and a top side of the substrate, the dielectric layer having a plurality of holes aligned with predetermined ones of the contact pads; a top side patterned metal layer on the dielectric film including portions extending into the holes electrically and thermally connected to contact pads of the device, and a backside metal layer on a substrate bottom side electrically and thermally connected to the spacer lower end surface.

US 2012 / 126 401 A1 relates to a stackable semiconductor assembly includes a semiconductor device, a heat spreader, an adhesive, a terminal, a plated through-hole and build-up circuitry. The heat spreader includes a bump, a base and a flange. The bump defines a cavity. The semiconductor device is mounted on the bump at the cavity, electrically connected to the build-up circuitry and thermally connected to the bump. The bump extends from the base into an opening in the adhesive, the base extends vertically from the bump opposite the cavity and the flange extends laterally from the bump at the cavity entrance. The build-up circuitry provides signal routing for the semiconductor device. The plated through-hole provides signal routing between the build-up circuitry and the terminal. The heat spreader provides heat dissipation for the semiconductor device.

US 2019 / 043 734 A1 relates to an electronics package includes an insulating substrate, an electrical component having an active surface coupled to a first surface of the insulating substrate, and an insulating structure disposed adjacent the electrical component on the first surface of the insulating substrate. A first wiring layer is formed on a top surface of the insulating structure and extends down at least one sloped side surface of the insulating structure. A second wiring layer is formed on a second surface of the insulating substrate. The second wiring layer extends through a plurality of vias in the insulating substrate to electrically couple at least one contact pad on the active surface of the electrical component to the first wiring layer.

WO 2018 / 111 484 A1 relates to an electronics package that includes an insulating substrate, a semiconductor device having a top surface coupled to a first side of the insulating substrate, and a pass-through component coupled to the first side of the insulating substrate. The pass-through component includes an insulating core and at least one through-hole structure comprising a conductive body extending through the thickness of the insulating core. A metallization layer is formed on a second side of the insulating substrate and extends through at least one via in the insulating substrate to electrically couple at least one conductive pad on the top surface of the semiconductor device to the at least one through-hole structure. An insulating material surrounds the semiconductor device and the insulating core of the pass-through component.

US 2014 / 138 806 A1 relates to a power overlay (POL) packaging structure that incorporates a leadframe connection is disclosed. The a POL structure includes a POL sub-module having a dielectric layer, at least one semiconductor device attached to the dielectric layer and that includes a substrate composed of a semiconductor material and a plurality of connection pads formed on the substrate, and a metal interconnect structure electrically coupled to the plurality of connection pads of the at least one semiconductor device, with the metal interconnect structure extending through vias formed through the dielectric layer so as to be connected to the plurality of connection pads. The POL structure also includes a leadframe electrically coupled to the POL sub-module, with the leadframe comprising leads configured to make an interconnection to an external circuit structure.

US 2020 / 266 132 A1 relates to a semiconductor device that comprises a substrate having a top surface and a bottom surface, an electronic device on the bottom surface of the substrate, a leadframe on the bottom surface of the substrate, the leadframe comprising a paddle, wherein the paddle is coupled to the electronic device, and a lead electrically coupled to the electronic device. The semiconductor device further comprises a first protective material contacting the bottom surface of the substrate and a side surface of the electronic device.

US 2022 / 181 287 A1 relates to a semiconductor device that includes a substrate, an adhesive layer formed on a lower surface of the substrate, a semiconductor element adhered to a lower surface of the adhesive layer, a through hole extending through the substrate and the adhesive layer and exposing a first electrode arranged on an upper surface of the semiconductor element, a via wiring formed in the through hole, a wiring layer formed on an upper surface of the substrate and electrically connected to the first electrode through the via wiring, and a protective insulation layer formed on the lower surface of the adhesive layer. The protective insulation layer covers an entirety of all side surfaces of the semiconductor element and a peripheral part of a lower surface of the semiconductor element and exposes a central part of the lower surface of the semiconductor element.

However, in the semiconductor device having the structure in which the electronic component is bonded to the metal plate, there is a problem in that it is difficult to sufficiently radiate heat generated from the electronic component. In other words, the thickness of the metal plate bonded to the electronic component is relatively thin, so that the heat generated from the electronic component is conducted in a thickness direction of the metal plate, and is then radiated to the outside. However, dispersion of heat in a surface direction of the metal plate (in the direction perpendicular to the thickness direction) is not sufficiently performed when compared to a case where heat is conducted in the thickness direction of the metal plate, so that the efficiency of heat radiation is not very high. As a result of this, in a case of an electronic component from which a relatively large amount of heat is generated, it is difficult to sufficiently radiate heat from the electronic component.

Accordingly, the disclosed technology has been conceived in light of the circumstances described above and an object thereof is to provide a semiconductor device and a method of manufacturing the semiconductor device capable of improving the heat radiation efficiency.

### SUMMARY

The subject-matter of the independent claims solves the above technical problem. The dependent claims relate to further embodiments of the present invention, and this description explains how the present invention may be carried out. According to an aspect of an embodiment, a semiconductor device includes an insulating base material that includes an adhesive layer on one of surfaces of the insulating base material; an electronic component that is fixed to the one of the surfaces of the insulating base material by way of the adhesive layer; a metal plate that is arranged so as to sandwich the electronic component with the one of the surfaces of the insulating base material; a sealing resin that is filled between the insulating base material and the metal plate, and that covers the electronic component; a wiring layer that is formed on another of the surfaces of the insulating base material, and that is connected to the electronic component by way of a via that passes through the insulating base material and the adhesive layer; and a metal layer that is made of a same metal material as that used for the wiring layer and the via, and that covers a surface of the metal plate located on a side opposite to a surface that is covered by the sealing resin.

### BRIEF DESCRIPTION OF DRAWINGS

FIG. 1 is a diagram illustrating a configuration of a semiconductor device according to an embodiment;
FIG. 2 is a flowchart illustrating a method of manufacturing the semiconductor device according to the embodiment;
FIG. 3 is a diagram illustrating a specific example of an insulating base material;
FIG. 4 is a diagram illustrating a specific example of an adhesive layer forming process;
FIG. 5 is a diagram illustrating a specific example of a via hole forming process;
FIG. 6 is a diagram illustrating a specific example of an electronic component fixing process;
FIG. 7 is a diagram illustrating a specific example of a seed layer forming process;
FIG. 8 is a diagram illustrating a specific example of an outer peripheral portion cutting process;
FIG. 9 is a diagram illustrating a specific example of a bonding process;
FIG. 10 is a diagram illustrating a specific example of a resin sealing process;
FIG. 11 is a diagram illustrating a specific example of an electrolytic copper plating process;
FIG. 12 is a diagram illustrating a specific example of a wiring layer forming process;
FIG. 13 is a diagram illustrating a specific example of a surface treatment layer forming process; and
FIG. 14 is a diagram illustrating implementation of the semiconductor device.

### DESCRIPTION OF EMBODIMENT

Preferred embodiment of a semiconductor device and a method of manufacturing the semiconductor device disclosed in the present invention will be described in detail below with reference to the accompanying drawings. Furthermore, the disclosed technology is not limited by the embodiment.

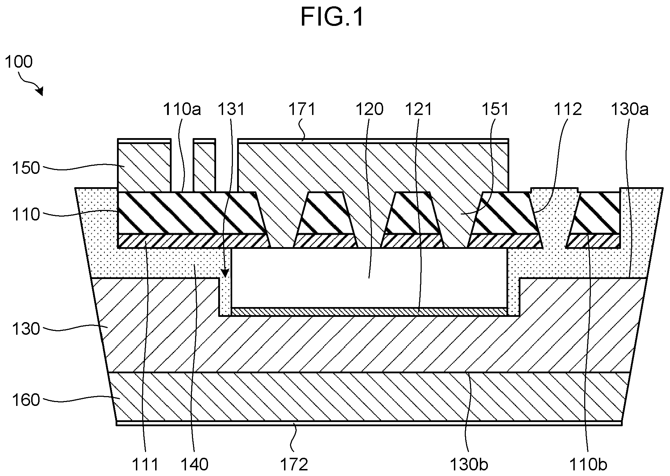

FIG. 1 is a diagram illustrating a configuration of a semiconductor device 100 according to an embodiment. In FIG. 1, a cross-sectional view of the semiconductor device 100 is schematically illustrated. Furthermore, in the description below, a surface closer to a mounting substrate when the semiconductor device 100 is mounted on the mounting substrate is referred to as a "lower surface", whereas a surface away from the mounting substrate is referred to as an "upper surface", and a vertical direction is defined based on this. However, the semiconductor device 100 may be manufactured and used by being inverted vertically, for example, or may be manufactured and used in an arbitrary posture.

The semiconductor device 100 illustrated in FIG. 1 includes an insulating base material 110 and a metal plate 130, and includes a sealing resin 140 that covers an electronic component 120 that is arranged by being sandwiched between a lower surface 110b (one example of one of the surfaces) of the insulating base material 110 and the metal plate 130. Furthermore, the semiconductor device 100 includes a wiring layer 150 that is formed on an upper surface 110a of the insulating base material 110 exposed from the sealing resin 140, and an electrolytic copper plating layer 160 (one example of a metal layer) that covers a lower surface 130b of the metal plate 130 exposed from the sealing resin 140.

The insulating base material 110 is a member in the form of a film, and includes an adhesive layer 111 below the lower surface 110b. The material used for the insulating base material 110 may be, for example, an insulation property resin, such as a polyimide-based resin, a polyethylene-based resin, or an epoxy-based resin. The thickness of the insulating base material 110 may be set to, for example, about 25 µm to 200 µm. The material used for the adhesive layer 111 may be, for example, a thermosetting resin, such as an epoxy-based resin, a polyimide-based resin, or a silicon-based resin. The thickness of the adhesive layer 111 may be set to, for example, about 10 µm to 60 µm. Furthermore, in the insulating base material 110 and the adhesive layer 111, a through-hole 112 that passes through the insulating base material 110 and the adhesive layer 111 in the thickness direction is arranged at a position that does not overlap with the wiring layer 150.

The electronic component 120 is an electronic component in which electronic circuits having various functions are integrated on a semiconductor. The electronic component 120 is fixed to the lower surface 110b of the insulating base material 110 by way of the adhesive layer 111.

The electronic component 120 used may be, for example, a semiconductor element constituted by using silicon (Si) or silicon carbide (SiC). Furthermore, the electronic component 120 may also be a semiconductor element constituted by using gallium nitride (GaN), gallium arsenide (GaAs), or the like. For example, the electronic component 120 used may be a semiconductor element (for example, a silicon chip for a CPU or the like), an Insulated Gate Bipolar Transistor (IGBT), a Metal-Oxide-Semiconductor Field-Effect Transistor (MOSFET), diode, or the like functioning as an active element.

The metal plate 130 is arranged by sandwiching the electronic component 120 with the lower surface 110b of the insulating base material 110. The metal plate 130 is bonded to the electronic component 120 that is fixed to the lower surface 110b of the insulating base material 110. The metal plate 130 absorbs heat generated from the electronic component 120, and radiates the heat to the outside by way of the electrolytic copper plating layer 160. The material used for the metal plate 130 may be, for example, copper or a copper alloy. The thickness of the metal plate 130 may be set to, for example, about 100 µm to 2000 µm.

The metal plate 130 is bonded to the electronic component 120 on an upper surface 130a. On the upper surface 130a of the metal plate 130, a recess portion 131 may be formed at a position corresponding to a position of the electronic component 120. In such a case, the electronic component 120 is accommodated in the recess portion 131, and is bonded to the bottom surface of the recess portion 131 by way of, for example, a conductive bonding member 121 constituted by using solder paste, or the like.

As a result of the recess portion 131 being formed on the upper surface 130a of the metal plate 130, an excessive spread of an area of the conductive bonding member 121 is controlled. Furthermore, the electronic component 120 that is fixed to the lower surface 110b of the insulating base material 110 is accommodated in and bonded to the recess portion 131 formed on the metal plate 130, so that a gap between the metal plate 130 and the insulating base material 110 is reduced and the semiconductor device 100 accordingly becomes thinner. Moreover, an example of the conductive bonding member 121 includes, in addition to solder paste, silver (Ag) paste.

The sealing resin 140 is, for example, an insulation property resin, such as a thermosetting epoxy-based resin; is filled between the insulating base material 110 and the metal plate 130; and covers the electronic component 120. Furthermore, the sealing resin 140 covers the side surface of the insulating base material 110 extending to the side surface of the insulating base material 110. The side surface of the insulating base material 110 is covered by the sealing resin 140, which makes it possible to prevent moisture intrusion from the side surface of the insulating base material 110. Consequently, it is possible to prevent the electronic component 120 from being damaged caused by water absorbed by the insulating base material 110. Furthermore, some of the sealing resin 140 is filled in the through-hole 112 that passes through the insulating base material 110 and the adhesive layer 111. As a result of some of the sealing resin 140 being filled in the through-hole 112, adhesion between the sealing resin 140, and the insulating base material 110 and the adhesive layer 111 is improved by the anchor effect.

The wiring layer 150 is formed on the upper surface 110a of the insulating base material 110. The wiring layer 150 is electrically connected to the electronic component 120 by a via 151 that passes through the insulating base material 110 and the adhesive layer 111. The wiring layer 150 and the via 151 are forms by performing electrolytic copper plating using, for example, copper or a copper alloy. The thickness of the wiring layer 150 (the thickness of a portion other than the via 151) may be set to, for example, about 25 µm to 300 µm.

An upper surface of the wiring layer 150 and a part of a side surface of the wiring layer 150 are exposed from the sealing resin 140. As a result of the upper surface of the wiring layer 150 and the part of the side surface of the wiring layer 150 being exposed from the sealing resin 140, heat generated from the electronic component 120 is conducted to the wiring layer 150 by way of the via 151, and is efficiently radiated from the upper surface of the wiring layer 150 and the part of the side surface of the wiring layer 150.

on the upper surface of the wiring layer 150 exposed from the sealing resin 140, a surface treatment layer 171 (one example of a first surface treatment layer) is formed. The surface treatment layer 171 is a plating layer in which a nickel (Ni) layer, a palladium (Pd) layer, and a gold (Au) layer are sequentially laminated in this order. The surface treatment layer 171 is able to be formed by using, for example, an electrolytic plating method or an electroless plating method. The surface treatment layer 171 used may be a Ni/Au layer or an Au layer, instead of the Ni/Pd/Au layer. As a result of the surface treatment layer 171 being formed on the upper surface of the wiring layer 150, it is possible to enhance the solder wetting characteristics with respect to the upper surface of the wiring layer 150.

The electrolytic copper plating layer 160 covers the lower surface 130b of the metal plate 130 exposed from the sealing resin 140. The electrolytic copper plating layer 160 is formed by using the same metal material as that used for the wiring layer 150 and the via 151, that is, formed by using copper or a copper alloy. The electrolytic copper plating layer 160 is formed at the same time as when, for example, the electrolytic copper plating layer and the via 151 constituting the wiring layer 150 are formed by performing electrolytic copper plating. The thickness of the electrolytic copper plating layer 160 may be set to, for example, about 25 µm to 300 µm.

In the embodiment, as a result of the electrolytic copper plating layer 160 covering the lower surface 130b of the metal plate 130, it is possible to practically increase the thickness of the metal plate 130 by an amount corresponding to the thickness of the electrolytic copper plating layer 160. Accordingly, in addition to conduction of heat to the metal plate 130 in the thickness direction, it is possible to facilitate dispersion of heat in the surface direction of the metal plate 130 (in the direction perpendicular to the thickness direction). As a result of this, it is possible to improve the heat radiation efficiency of the semiconductor device 100.

A surface treatment layer 172 (one example of a second surface treatment layer) is formed on the lower surface of the electrolytic copper plating layer 160. The surface treatment layer 172 is a plating layer made of the same metal material as that used for the surface treatment layer 171, and is a plating layer in which, similarly to the surface treatment layer 171, a Ni layer, a Pd layer, and an Au layer are sequentially laminated in this order. The surface treatment layer 172 is formed at the same time when the surface treatment layer 171 is formed by using, for example, an electrolytic plating method or an electroless plating method. The surface treatment layer 172 used may be a Ni/Au layer or an Au layer, instead of the Ni/Pd/Au layer. As a result of the surface treatment layer 172 being formed on the lower surface of the electrolytic copper plating layer 160, it is possible to enhance the solder wetting characteristics with respect to the lower surface of the electrolytic copper plating layer 160.

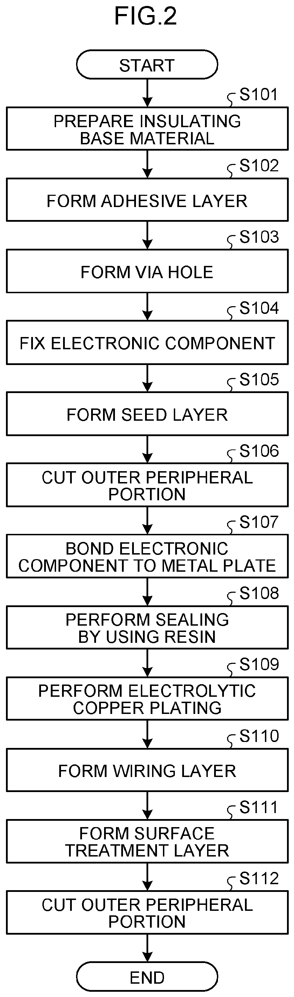

In the following, a method of manufacturing the semiconductor device 100 that is constituted as described above will be described with reference to FIG. 2 by using specific examples. FIG. 2 is a flowchart illustrating the method of manufacturing the semiconductor device 100 according to the embodiment.

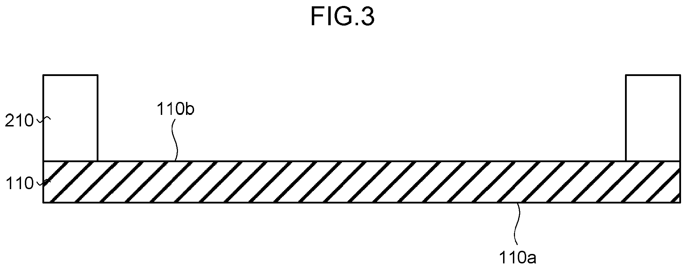

First, the insulating base material 110 is prepared (Step S101). Specifically, as illustrated in, for example, FIG. 3, a support frame 210 having a rectangular shape is fixed to the lower surface 110b of the insulating base material 110. FIG. 3 is a diagram illustrating a specific example of the insulating base material. The material used for the insulating base material 110 may be, for example, an insulation property resin, such as a polyimide-based resin, a polyethylene-based resin, or an epoxy-based resin.

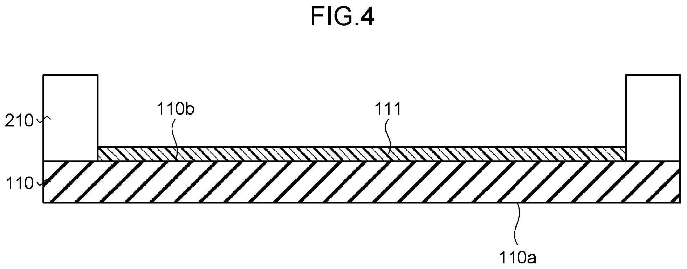

Subsequently, the adhesive layer 111 is formed on the lower surface 110b of the insulating base material 110 (Step S102). Specifically, as illustrated in, for example, FIG. 4, in an area surrounded by the support frame 210, the adhesive layer 111 that is in a semi cured state is formed on the lower surface 110b of the insulating base material 110 by using, for example, a spin coating technique. FIG. 4 is a diagram illustrating a specific example of an adhesive layer forming process. The material used for the adhesive layer 111 may be, for example, a thermosetting resin, such as an epoxy-based resin, a polyimide-based resin, or a silicon-based resin.

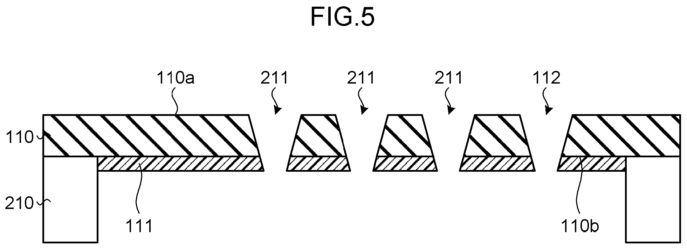

Subsequently, a via hole is formed in the insulating base material 110 and the adhesive layer 111 (Step S103). Specifically, in the area in which the wiring layer 150 (see FIG. 1) is to be formed, as illustrated in, for example FIG. 5, a via hole 211 passing through the insulating base material 110 and the adhesive layer 111 in the thickness direction is formed. At this time, the through-hole 112 passing through the insulating base material 110 and the adhesive layer 111 in the thickness direction at the position that is not overlapped with the position of the wiring layer 150 is formed in a manner adjacent to the via hole 211. FIG. 5 is a diagram illustrating a specific example of a via hole forming process. Each of the via hole 211 and the through-hole 112 has a tapered shape in which the diameter of each of the via hole 211 and the through-hole 112 decreases as each of the via hole 211 and the through-hole 112 is away from the upper surface 110a of the insulating base material 110. Each of the via hole 211 and the through-hole 112 is able to be formed by performing, for example, laser beam machining or punching processing.

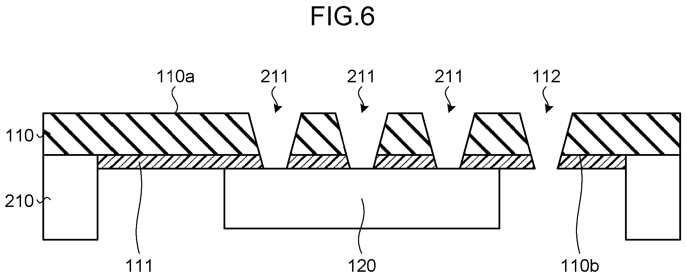

Subsequently, at the position of the via hole 211, the electronic component 120 is fixed to the lower surface 110b of the insulating base material 110 by way of the adhesive layer 111 (Step S104). Specifically, as illustrated in, for example, FIG. 6, the electronic component 120 is bonded to the lower surface 110b of the insulating base material 110 by way of the adhesive layer 111, and an electrode (not illustrated) of the electronic component 120 is exposed on the bottom of the via hole 211. When the electronic component 120 is adhered to the lower surface 110b of the insulating base material 110 by way of the adhesive layer 111, the adhesive layer 111 is thermally cured. FIG. 6 is a diagram illustrating a specific example of an electronic component fixing process.

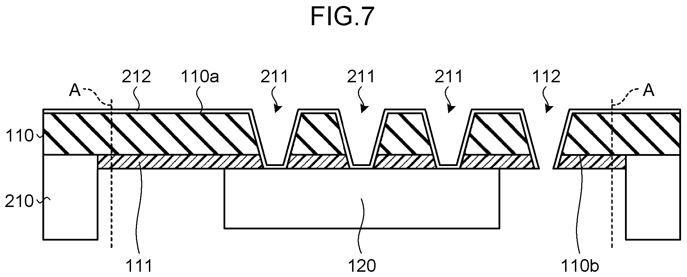

When the electronic component 120 is fixed, a seed layer is formed on the upper surface 110a of the insulating base material 110 (Step S105). Specifically, as illustrated in, for example, FIG. 7, a seed layer 212 that continuously covers the upper surface 110a of the insulating base material 110, the inner surface of the via hole 211, and the electrode (not illustrated) of the electronic component 120 exposed on the bottom of the via hole 211 is formed. At this time, the seed layer 212 is also formed in the interior of the through-hole 112. FIG. 7 is a diagram illustrating a specific example of a seed layer forming process. The process of forming the seed layer 212 is performed by using, for example, a sputtering method or an electroless plating method. The material used for the seed layer 212 may be, for example, copper (Cu), or the like. The thickness of the seed layer 212 may be set to, for example, about 10 nm to 1000 nm.

Furthermore, an adhesion layer may also be formed below the seed layer 212 as needed. A process of forming the adhesion layer is performed by using the sputtering method or the electroless plating method. The material used for the adhesion layer may be, for example, titanium, or the like. As a result of the adhesion layer being formed below the seed layer 212, adhesion of the seed layer 212 with respect to the upper surface 110a of the insulating base material 110 is improved. The thickness of the adhesion layer may be set to, for example, about 10 nm to 500 nm.

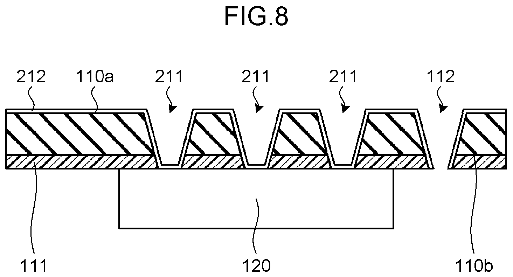

When the seed layer 212 has been formed, the outer peripheral portion of each of the insulating base material 110 and the adhesive layer 111 is cut by performing a dicing process (Step S106). Specifically, at a cutting line A (see FIG. 7) passing through the inner side of the support frame 210, the outer peripheral portion of each of the insulating base material 110 and the adhesive layer 111 is cut by, for example, a dicer or a slicer. As a result of this, as illustrated in, for example, FIG. 8, the support frame 210 is cut off from each of the insulating base material 110 and the adhesive layer 111. FIG. 8 is a diagram illustrating a specific example of an outer peripheral portion cutting process.

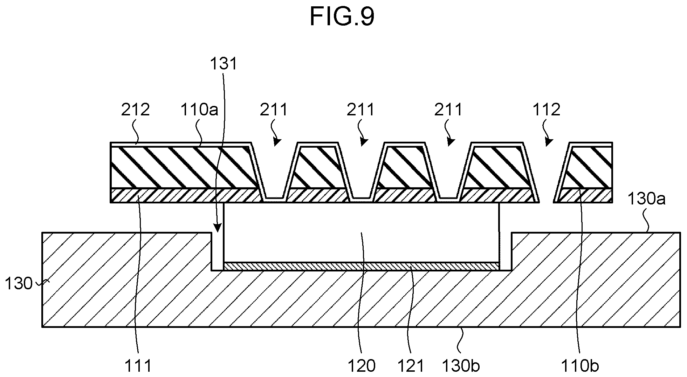

When the support frame 210 has been cut off, the electronic component 120 that is fixed on the lower surface 110b of the insulating base material 110 is bonded to the metal plate 130 (Step S107). Specifically, first, the metal plate 130 in which the recess portion 131 is formed on the upper surface 130a is prepared. Then, the electronic component 120 is accommodated in the recess portion 131 formed on the metal plate 130, and is bonded to the bottom surface of the recess portion 131 by way of the conductive bonding member 121 constituted by, for example, solder paste, or the like. As a result of this, as illustrated in, for example, FIG. 9, the intermediate structure in which the electronic component 120 is sandwiched by the insulating base material 110 and the metal plate 130 is formed. FIG. 9 is a diagram illustrating a specific example of a bonding process.

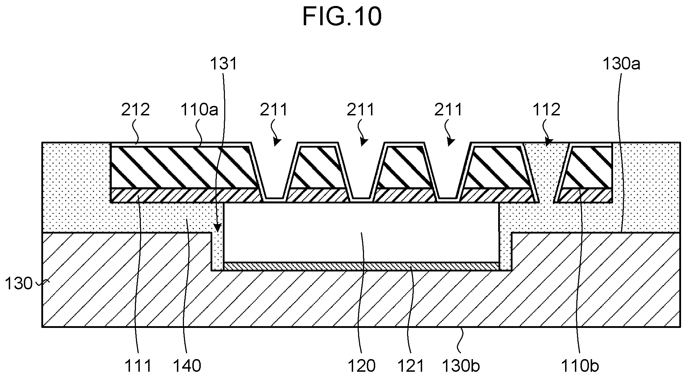

The intermediate structure is subjected to resin sealing by forming, for example, transfer molding (Step S108). In other words, the intermediate structure is accommodated in the metal mold, the sealing resin 140 that is an unsecured state is injected into the metal mold. Then, the sealing resin 140 is heated to a predetermined temperature and hardened. As the resin sealing method, in addition to the transfer molding technique, for example, a compression molding technique, an injection molding technique, and the like may be used. As a result of the intermediate structure being subjected to resin sealing, as illustrated in, for example, FIG. 10, the sealing resin 140 is filled in a gap between the insulating base material 110 and the metal plate 130, and the electronic component 120 is sealed. Furthermore, the sealing resin 140 extends to the side surface of the insulating base material 110, and thus, the side surface of the insulating base material 110 is sealed. Furthermore, some of the sealing resin 140 is filled in the through-hole 112 that passes through the insulating base material 110 and the adhesive layer 111. FIG. 10 is a diagram illustrating a specific example of a resin sealing process.

When the intermediate structure has been subjected to the resin sealing, electrolytic copper plating is performed on both of the upper surface 110a of the insulating base material 110 exposed from the sealing resin 140 and the lower surface 130b of the metal plate 130 exposed from the sealing resin 140 (Step S109). In other words, a resist layer is formed on the side surface of the metal plate 130, and power is supplied from both of the seed layer 212 and the metal plate 130, so that the electrolytic copper plating is performed on the entire surface of the intermediate structure. At this time, the lower surface 130b of the metal plate 130 is not covered by the resist layer, so that electrolyte copper is deposited to the lower surface 130b of the metal plate 130, as well as the upper surface 110a of the insulating base material 110 and the via hole 211.

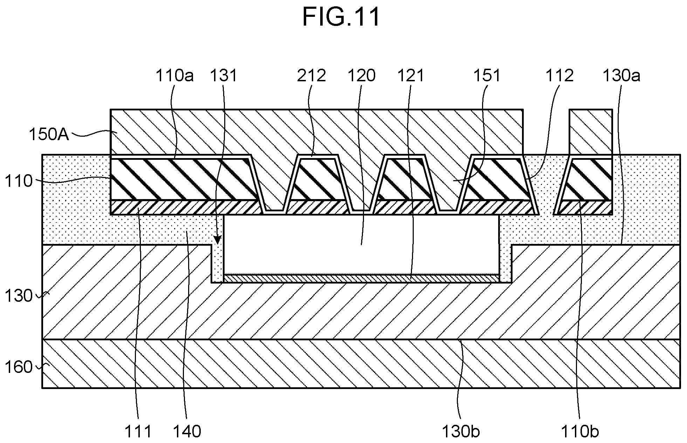

In other words, as illustrated in, for example, FIG. 11, an electrolytic copper plating layer 150A (one example of the metal layer disposed on the other of the surfaces of the insulating base material) is formed on the upper surface 110a of the insulating base material 110, and the via 151 is formed by electrolyte copper being filled into the via hole 211. Then, at the same time when the electrolytic copper plating layer 150A and the via 151 are formed, the electrolytic copper plating layer 160 is formed on the lower surface 130b of the metal plate 130. Therefore, the lower surface 130b of the metal plate 130 is covered by the electrolytic copper plating layer 160. FIG. 11 is a diagram illustrating a specific example of an electrolytic copper plating process. After having performed electrolytic copper plating, the resist layer that covers the side surface of the metal plate 130 is removed.

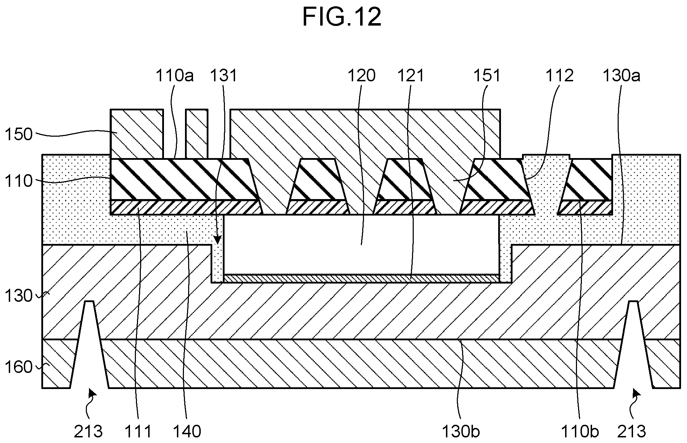

Then, the wiring layer 150 having a desired wiring pattern is formed from the electrolytic copper plating layer 150A (Step S110). The wiring layer 150 is formed from the electrolytic copper plating layer 150A by using, for example, a subtractive method. In other words, a resist layer that covers a portion remaining as a wiring pattern is formed on the upper surface of the electrolytic copper plating layer 150A. Then, the electrolytic copper plating layer 150A that is exposed without being covered by the resist layer is removed by an etching process. As a result of this, as illustrated in, for example, FIG. 12, the wiring layer 150 that has a desired wiring pattern and that is connected to the electronic component 120 by way of the via 151 is formed. FIG. 12 is a diagram illustrating a specific example of a wiring layer forming process. A part of each of the upper surface and the side surface of the wiring layer 150 is exposed from the sealing resin 140. When the wiring layer 150 has been formed, the resist layer is removed, the seed layer 212 disposed at the portion that is not covered by the wiring layer 150 is removed by a flash etching process by using the wiring layer 150 as a mask. Moreover, the seed layer 212 that is in contact with both of the wiring layer 150 and the via 151, and the seed layer 212 that is located in the interior of the through-hole 112 remain after the flash etching process has been performed; however, this state is not illustrated in FIG. 12.

When the seed layer 212 has been removed, a groove is formed in the outer peripheral portion of the metal plate 130 and the electrolytic copper plating layer 160. In other words, a resist layer having an opening is formed, on the lower surface of the electrolytic copper plating layer 160, at a position in which the groove is to be formed. Then, the outer peripheral portion of the metal plate 130 and the electrolytic copper plating layer 160 corresponding to a position of the opening of the resist layer is removed by performing a half etching process, so that a pair of grooves 213 is formed in the outer peripheral portion of the metal plate 130 and the electrolytic copper plating layer 160. Each of the grooves 213 has a tapered shape in which the width is gradually reduced in the depth direction.

Subsequently, for example, by using an electroless plating method, the surface treatment layer 171 that covers the upper surface of the wiring layer 150 is formed, and the surface treatment layer 172 that covers the lower surface of the electrolytic copper plating layer 160 is also formed (Step S111).

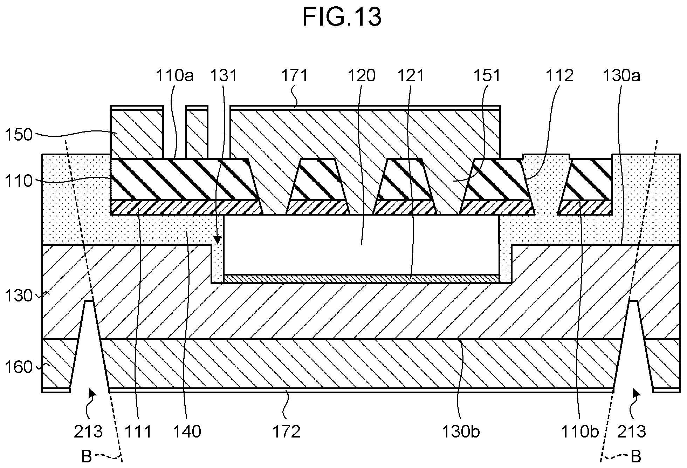

By performing the processes described up to here, as illustrated in, for example FIG. 13, a structure having the same structure of the semiconductor device 100 is obtained. FIG. 13 is a diagram illustrating a specific example of a surface treatment layer forming process. After that, the outer peripheral portion of the structure illustrated in FIG. 13 is cut by using a dicing process (Step S112). Specifically, at a cutting line B along the side surface of the groove 213 that has a tapered shape, the outer peripheral portion of each of the electrolytic copper plating layer 160, the metal plate 130, and the sealing resin 140 is cut by, for example, a dicer or a slicer, and, as a result of this, the semiconductor device 100 is obtained.

At this time, as a result of the outer peripheral portion of each of the electrolytic copper plating layer 160, the metal plate 130, and the sealing resin 140 being cut along the side surface of the groove 213 having the tapered shape, the side surface of each of the electrolytic copper plating layer 160, the metal plate 130, and the sealing resin 140 becomes a side surface having a tapered shape when viewed from the side. Therefore, the metal plate 130 has a tapered shape in which the width of the lower surface 130b that is exposed from the sealing resin 140 is smaller than the width of the upper surface 130a that is covered by the sealing resin 140. As a result of this, the size of the bottom surface of the semiconductor device 100 is reduced, and, when the semiconductor device 100 is packaged on the mounting substrate, it is possible to perform positional alignment between the pad disposed on the mounting substrate and the bottom surface of the semiconductor device 100 with high accuracy.

Moreover, the outer peripheral portion cutting process performed at Step S112 may be omitted as needed. In this case, the side surfaces of the electrolytic copper plating layer 160, the metal plate 130, and the sealing resin 140 become a linear side surface in a lateral view.

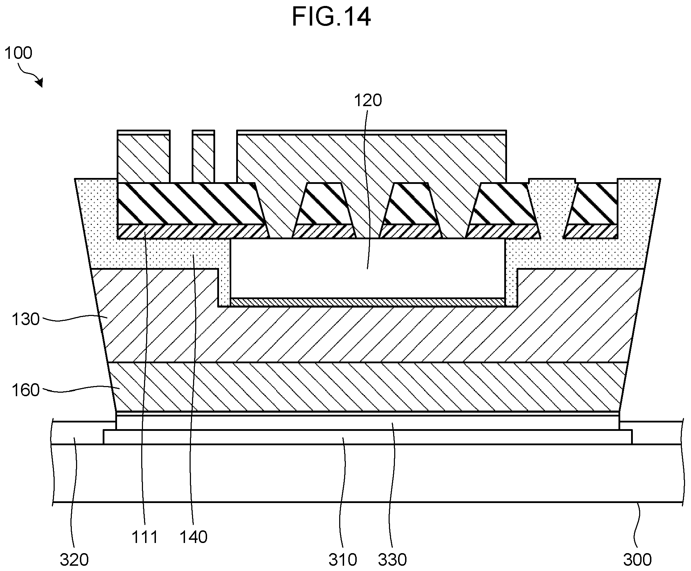

The semiconductor device 100 obtained by being cut is able to mount on a mounting substrate. Specifically, it is possible to mount the semiconductor device 100 on the mounting substrate by using both of the metal plate 130 and the electrolytic copper plating layer 160 as terminals. FIG. 14 is a diagram illustrating a mounting process of the semiconductor device 100.

As illustrated in FIG. 14, a pad 310 is formed in the wiring layer disposed on the upper surface of a mounting substrate 300, and the pad 310 is exposed from the opening portion of a solder resist layer 320. When the semiconductor device 100 is mounted on the mounting substrate 300, positional alignment between the electrolytic copper plating layer 160 and the pad 310 disposed on the mounting substrate 300 with respect to the bottom surface of the semiconductor device 100 is performed. Then, the electrolytic copper plating layer 160 and the pad 310 are bonded by a solder 330. At this time, the metal plate 130 has a tapered shape, so that the size of the electrolytic copper plating layer 160 disposed below the metal plate 130 is reduced, and it is thus possible to perform the positional alignment between the electrolytic copper plating layer 160 and the pad 310 with high accuracy.

In the state illustrated in FIG. 14, the heat generated from the electronic component 120 is conducted to the electrolytic copper plating layer 160 via the metal plate 130, and is radiated from the electrolytic copper plating layer 160 by way of the solder 330 and the pad 310. In other words, in addition to the heat being conducted in the thickness direction of the metal plate 130, it is possible to facilitate dispersion of heat in a surface direction of the metal plate 130 (in the direction perpendicular to the thickness direction) in the electrolytic copper plating layer 160, and, as a result of this, it is possible to improve the heat radiation efficiency of the semiconductor device 100.

As described above, the semiconductor device (as one example, the semiconductor device 100) according to the embodiment includes the insulating base material (as one example, the insulating base material 110), the electronic component (as one example, the electronic component 120), the metal plate (as one example, the metal plate 130), sealing resin (as one example, the sealing resin 140), the wiring layer (as one example, the wiring layer 150), and the metal layer (as one example, the electrolytic copper plating layer 160). The insulating base material includes the adhesive layer (as one example, the adhesive layer 111) on one of the surfaces (as one example, the lower surface 110b) of the insulating base material. The electronic component is fixed to one of the surfaces of the insulating base material by way of the adhesive layer. The metal plate is arranged so as to sandwich the electronic component with one of the surfaces of the insulating base material. The sealing resin is filled between the insulating base material and the metal plate, and covers the electronic component. The wiring layer is formed on the other of the surfaces (as one example, the upper surface 110a) of the insulating base material, and is connected to the electronic component by way of the via (as one example, the via 151) that passes through the insulating base material and the adhesive layer. The metal layer is made of the same metal material as that used for the wiring layer, and covers the surface (as one example, the lower surface 130b) of the metal plate located on a side opposite to the surface (as one example, the upper surface 130a) that is covered by the sealing resin. As a result of this, it is possible to improve the heat radiation efficiency.

According to an aspect of an embodiment of the semiconductor device disclosed in the present application, an advantage is provided in that it is possible to improve heat radiation efficiency.

## Claims

1. A semiconductor device (100) comprising:
an insulating base material (110) that includes an adhesive layer (111) on one (110b) of surfaces of the insulating base material (110);
an electronic component (120) that is fixed to the one (110b) of the surfaces of the insulating base material (110) by way of the adhesive layer (111);
a metal plate (130) that is arranged so as to sandwich the electronic component (120) with the one (110b) of the surfaces of the insulating base material (110);
a sealing resin (140)
that is filled between the insulating base material (110) and the metal plate (130), and
that covers the electronic component (120);
a wiring layer (150)
that is formed on another (110a) of the surfaces of the insulating base material (110), and
that is connected to the electronic component (120) by way of a via (151) that passes through the insulating base material (110) and the adhesive layer (111); and
a metal layer (160)
that is made of a same metal material as that used for the wiring layer (150) and the via (151), and
that covers a surface (130b) of the metal plate (130) located on a side opposite to a surface (130a) that is covered by the sealing resin (140), wherein
the sealing resin (140) covers the electronic component (120) and seals a side surface of the insulating base material (110),
an upper surface of the wiring layer (150) and a part of a side surface of the wiring layer (150) are exposed from the sealing resin (140), and
side surfaces of the metal plate (130) and metal layer (160) are exposed from the sealing resin (140).

2. The semiconductor device (100) according to claim 1, further comprising
a first surface treatment layer (171) that covers the upper surface of the wiring layer (150) exposed from the sealing resin (140), and
a second surface treatment layer (172)
that is made of a same metal material as that used for the first surface treatment layer (171), and
that covers a surface of the metal layer (160) located on a side opposite to a surface that is in contact with the metal plate (130).

3. The semiconductor device (100) according to claim 1, wherein the metal plate (130) has a tapered shape in which a width of the surface (130b) of the metal plate (130) located on the side opposite to the surface (130a) that is covered by the sealing resin (140) is smaller than a width of the surface (130a) that is covered by the sealing resin (140).

4. The semiconductor device (100) according to claim 1, wherein
the metal plate (130) includes a recess portion (131), on the surface (130a) that is covered by the sealing resin (140), at a position corresponding to a position of the electronic component (120), and
the electronic component (120) is accommodated in the recess portion (131), and is bonded to a bottom surface of the recess portion (131).

5. The semiconductor device (100) according to claim 1, wherein
the insulating base material (110) and the adhesive layer (111) include a through-hole (112) that passes through the insulating base material (110) and the adhesive layer (111) in a thickness direction at a position that does not overlap with a position of the wiring layer (150), and
a part of the sealing resin (140) is filled in the through-hole (112).

6. A method of manufacturing a semiconductor device (100), the method comprising:
forming (S102) an adhesive layer (111) on one (110b) of surfaces of an insulating base material (110);
forming (S103) a via hole (211) that passes through the insulating base material (110) and the adhesive layer (111);
fixing (S104) an electronic component (120) to the one (110b) of the surfaces of the insulating base material (110) at a position of the via hole (211) by way of the adhesive layer (111);
arranging (S107) a metal plate (130) so as to sandwich the electronic component (120) with the one (110b) of the surfaces of the insulating base material (110);
bonding (S107) the electronic component (120) to the metal plate (130);
filling (S108) a sealing resin (140) between the insulating base material (110) and the metal plate (130);
forming (S109), by performing plating using a metal material, a metal layer (150A) on another (110a) of the surfaces of the insulating base material (110) and a via (151) in the via hole (211), the via (151) connecting the metal layer (150A) and the electronic component (120);
forming (S109), in parallel with the forming (S109) the metal layer (150A) and the via (151), a metal layer (160) that is made of the metal material and that covers a surface (130b) of the metal plate (130) located on a side opposite to a surface (130a) that is in contact with the sealing resin (140); and
forming (S110) a wiring layer (150) that is connected to the electronic component (120) by way of the via (151) by performing etching on the metal layer (150A) located on the other (110a) of the surfaces of the insulating base material (110), wherein
the sealing resin (140) covers the electronic component (120) and seals a side surface of the insulating base material (110),
an upper surface of the wiring layer (150) and a part of a side surface of the wiring layer (150) are exposed from the sealing resin (140), and
side surfaces of the metal plate (130) and metal layer (160) are exposed from the sealing resin (140).

## Patentansprüche

1. Halbleitervorrichtung (100), umfassend:
ein isolierendes Basismaterial (110), das auf einer (110b) von der Flächen des isolierenden Basismaterials (110) eine Klebeschicht (111) einschließt;
eine elektronische Komponente (120), die über die Klebeschicht (111) an der einen (110b) von der Flächen des isolierenden Basismaterials (110) befestigt ist;
eine Metallplatte (130), die so angeordnet ist, dass sie die elektronische Komponente (120) mit der einen (110b) von der Flächen des isolierenden Basismaterials (110) zwischen sich aufnimmt;
ein Vergussharz (140),
das zwischen dem isolierenden Basismaterial (110) und der Metallplatte (130) eingefüllt ist und
das die elektronische Komponente (120) bedeckt;
eine Verdrahtungsschicht (150),
die auf einer anderen (110a) von Flächen des isolierenden Basismaterials (110) gebildet ist, und
die über eine Durchkontaktierung (151), die durch das isolierende Basismaterial (110) und die Klebeschicht (111) hindurchgeht, mit der elektronischen Komponente (120) verbunden ist; und
eine Metallschicht (160),
die aus demselben Metallmaterial besteht wie das für die Verdrahtungsschicht (150) und die Durchkontaktierung (151) verwendete, und
die eine Fläche (130b) der Metallplatte (130) bedeckt, die sich auf einer der Fläche (130a) gegenüberliegenden Seite befindet, die von dem Vergussharz (140) bedeckt ist, wobei
das Vergussharz (140) die elektronische Komponente (120) bedeckt und eine Seitenfläche des isolierenden Basismaterials (110) abdichtet,
eine Oberseite der Verdrahtungsschicht (150) und ein Teil einer Seitenfläche der Verdrahtungsschicht (150) aus dem Vergussharz (140) freiliegend sind und
Seitenflächen der Metallplatte (130) und der Metallschicht (160) aus dem Vergussharz (140) freiliegend sind

2. Halbleitervorrichtung (100) nach Anspruch 1, weiter umfassend
eine erste Oberflächenbehandlungsschicht (171), die die aus dem Vergussharz (140) freiliegende Oberseite der Verdrahtungsschicht (150) bedeckt, und
eine zweite Oberflächenbehandlungsschicht (172),
die aus demselben Metallmaterial besteht wie das für die erste Oberflächenbehandlungsschicht (171) verwendete, und
die eine Fläche der Metallschicht (160) bedeckt, die sich auf einer der Fläche gegenüberliegenden Seite befindet, die mit der Metallplatte (130) in Kontakt ist.

3. Halbleitervorrichtung (100) nach Anspruch 1, wobei die Metallplatte (130) eine sich verjüngende Form aufweist, bei der eine Breite der Fläche (130b) der Metallplatte (130), die sich auf der Fläche (130a), die von dem Vergussharz (140) bedeckt ist, gegenüberliegenden Seite befindet, kleiner ist als eine Breite der Fläche (130a), die von dem Vergussharz (140) bedeckt ist.

4. Halbleitervorrichtung (100) nach Anspruch 1, wobei
die Metallplatte (130) auf der Fläche (130a), die von dem Vergussharz (140) bedeckt ist, an einer Position, die einer Position der elektronischen Komponente (120) entspricht, eine Vertiefung (131) einschließt, und
die elektronische Komponente (120) in der Vertiefung (131) aufgenommen ist und mit einer Bodenfläche der Vertiefung (131) verbunden ist.

5. Halbleitervorrichtung (100) nach Anspruch 1, wobei
das isolierende Basismaterial (110) und die Klebeschicht (111) ein Durchgangsloch (112) einschließen, das das isolierende Basismaterial (110) und die Klebeschicht (111) an einer Position, die sich nicht mit einer Position der Verdrahtungsschicht (150) überlappt, in einer Dickenrichtung durchdringt, und
ein Teil des Vergussharzes (140) in das Durchgangsloch (112) eingefüllt ist.

6. Verfahren zur Herstellung einer Halbleitervorrichtung (100), wobei das Verfahren umfasst:
Bilden (S102) einer Klebeschicht (111) auf einer (110b) von Flächen eines isolierenden Basismaterials (110);
Bilden (S103) eines Durchkontaktierungslochs (211), das das isolierende Basismaterial (110) und die Klebeschicht (111) durchdringt;
Befestigen (S104) einer elektronischen Komponente (120) an der einen (110b) von Flächen des isolierenden Basismaterials (110) an einer Position des Durchkontaktierungslochs (211) über die Klebeschicht (111);
Anordnen (S107) einer Metallplatte (130) so, dass sie die elektronische Komponente (120) mit der einen (110b) von Flächen des isolierenden Basismaterials (110) zwischen sich aufnimmt;
Verbinden (S107) der elektronischen Komponente (120) mit der Metallplatte (130);
Einfüllen (S108) eines Vergussharzes (140) zwischen dem isolierenden Basismaterial (110) und der Metallplatte (130);
Bilden (S109), durch Durchführen einer Plattierung unter Verwendung von einem Metallmaterial, einer Metallschicht (150A) auf einer anderen (110a) von Flächen des isolierenden Basismaterials (110) und einer Durchkontaktierung (151) in dem Durchkontaktierungsloch (211), wobei die Durchkontaktierung (151) die Metallschicht (150A) und die elektronische Komponente (120) verbindet;
Bilden (S109), parallel zu dem Bilden (S109) der Metallschicht (150A) und der Durchkontaktierung (151), einer Metallschicht (160), die aus dem Metallmaterial besteht und eine Fläche (130b) der Metallplatte (130) bedeckt, die sich auf einer der Fläche (130a), die mit dem Vergussharz (140) in Kontakt ist, gegenüberliegenden Seite befindet; und
Bilden (S110) einer Verdrahtungsschicht (150), die über die Durchkontaktierung (151) mit der elektronischen Komponente (120) verbunden ist, durch Durchführen von Ätzen an der Metallschicht (150A), die sich auf der anderen (110a) von Flächen des isolierenden Basismaterials (110) befindet, wobei
das Vergussharz (140) die elektronische Komponente (120) bedeckt und eine Seitenfläche des isolierenden Basismaterials (110) abdichtet,
eine Oberseite der Verdrahtungsschicht (150) und ein Teil einer Seitenfläche der Verdrahtungsschicht (150) aus dem Vergussharz (140) freiliegend sind und
Seitenflächen der Metallplatte (130) und der Metallschicht (160) aus dem Vergussharz (140) freiliegend sind.

## Revendications

1. Dispositif semi-conducteur (100) comprenant :
un matériau de base isolant (110) qui inclut une couche adhésive (111) sur une surface (110b) parmi les surfaces du matériau de base isolant (110) ;
un composant électronique (120) qui est fixé à la surface (110b) parmi les surfaces du matériau de base isolant (110) au moyen de la couche adhésive (111) ;
une plaque métallique (130) qui est agencée de manière à prendre en sandwich le composant électronique (120) avec la surface (110b) parmi les surfaces du matériau de base isolant (110) ;
une résine d'étanchéité (140)
qui est injectée entre le matériau de base isolant (110) et la plaque métallique (130), et
qui recouvre le composant électronique (120) ;
une couche de câblage (150)
qui est formée sur une autre surface (110a) parmi les surfaces du matériau de base isolant (110), et
qui est connectée au composant électronique (120) au moyen d'une interconnexion (151) qui traverse le matériau de base isolant (110) et la couche adhésive (111) ; et
une couche métallique (160)
qui est constituée d'un même matériau métallique que celui utilisé pour la couche de câblage (150) et l'interconnexion (151), et
qui recouvre une surface (130b) de la plaque métallique (130) située sur un côté opposé à une surface (130a) qui est recouverte par la résine d'étanchéité (140), dans lequel
la résine d'étanchéité (140) recouvre le composant électronique (120) et assure l'étanchéité d'une surface latérale du matériau de base isolant (110),
une surface supérieure de la couche de câblage (150) et une partie d'une surface latérale de la couche de câblage (150) sont exposées à partir de la résine d'étanchéité (140), et
des surfaces latérales de la plaque métallique (130) et de la couche métallique (160) sont exposées à partir de la résine d'étanchéité (140).

2. Dispositif semi-conducteur (100) selon la revendication 1, comprenant en outre
une première couche de traitement de surface (171) qui recouvre la surface supérieure de la couche de câblage (150) exposée hors de la résine d'étanchéité (140), et
une deuxième couche de traitement de surface (172)
qui est constituée d'un même matériau métallique que celui utilisé pour la première couche de traitement de surface (171), et
qui recouvre une surface de la couche métallique (160) située sur un côté opposé à une surface qui est en contact avec la plaque métallique (130).

3. Dispositif semi-conducteur (100) selon la revendication 1, dans lequel la plaque métallique (130) présente une forme effilée dans laquelle une largeur de la surface (130b) de la plaque métallique (130) située sur le côté opposé à la surface (130a) qui est recouverte par la résine d'étanchéité (140) est plus petite qu'une largeur de la surface (130a) qui est recouverte par la résine d'étanchéité (140).

4. Dispositif semi-conducteur (100) selon la revendication 1, dans lequel la plaque métallique (130) inclut une portion d'évidement (131) sur la surface (130a) qui est recouverte par la résine d'étanchéité (140), à une position correspondant à une position du composant électronique (120), et
le composant électronique (120) est logé dans la portion d'évidement (131), et est lié à une surface inférieure de la portion d'évidement (131).

5. Dispositif semi-conducteur (100) selon la revendication 1, dans lequel
le matériau de base isolant (110) et la couche adhésive (111) incluent un trou traversant (112) qui traverse le matériau de base isolant (110) et la couche adhésive (111) dans une direction d'épaisseur à une position qui ne chevauche pas une position de la couche de câblage (150), et
une partie de la résine d'étanchéité (140) est injectée dans le trou traversant (112).

6. Procédé de fabrication d'un dispositif semi-conducteur (100), le procédé comprenant :
la formation (S102) d'une couche adhésive (111) sur une surface (110b) parmi les surfaces d'un matériau de base isolant (110) ;
la formation (S103) d'un trou (211) d'interconnexion qui traverse le matériau de base isolant (110) et la couche adhésive (111) ;
la fixation (S104) d'un composant électronique (120) à la surface (110b) parmi les surfaces du matériau de base isolant (110) à une position du trou (211) d'interconnexion au moyen de la couche adhésive (111) ;
l'agencement (S107) d'une plaque métallique (130) de manière à prendre en sandwich le composant électronique (120) avec la surface (110b) parmi les surfaces du matériau de base isolant (110) ;
la liaison (S107) du composant électronique (120) à la plaque métallique (130) ;
l'injection (S108) d'une résine d'étanchéité (140) entre le matériau de base isolant (110) et la plaque métallique (130) ;
la formation (S109), par réalisation d'un placage utilisant un matériau métallique, d'une couche métallique (150A) sur une autre surface (110a) parmi les surfaces du matériau de base isolant (110) et d'une interconnexion (151) dans le trou (211) d'interconnexion, l'interconnexion (151) connectant la couche métallique (150A) et le composant électronique (120) ;
la formation (S109), parallèlement à la formation (S109) de la couche métallique (150A) et de l'interconnexion (151), d'une couche métallique (160) qui est constituée du matériau métallique et qui recouvre une surface (130b) de la plaque métallique (130) située sur un côté opposé à une surface (130a) qui est en contact avec la résine d'étanchéité (140) ; et
la formation (S110) d'une couche de câblage (150) qui est connectée au composant électronique (120) au moyen de l'interconnexion (151) par réalisation d'une gravure sur la couche métallique (150A) située sur l'autre surface (110a) parmi les surfaces du matériau de base isolant (110), dans lequel
la résine d'étanchéité (140) recouvre le composant électronique (120) et assure l'étanchéité d'une surface latérale du matériau de base isolant (110),
une surface supérieure de la couche de câblage (150) et une partie d'une surface latérale de la couche de câblage (150) sont exposées à partir de la résine d'étanchéité (140), et
des surfaces latérales de la plaque métallique (130) et de la couche métallique (160) sont exposées à partir de la résine d'étanchéité (140).
